# EUROPEAN PATENT APPLICATION

(11) **EP 2 485 273 A2**
(43) Date of publication of application: **08.08.2012**
(21) Application number: 10820859.6
(22) Date of filing: 30.09.2010
(51) Int. Cl.: H01L 31/042

(54) **SOLAR PHOTOVOLTAIC DEVICE AND A PRODUCTION METHOD FOR THE SAME**

(30) Priority: 01.10.2009 KR 20090094005; 01.10.2009 KR 20090093692
(71) Applicant: LG Innotek Co., Ltd., Seoul 100-714 (KR)
(72) Inventor: JEE, Suk Jae, Seoul 100-714 (KR)
(74) Representative: Novagraaf Technologies
(86) International application number: PCT/KR2010/006713
(87) International publication number: WO 2011/040786

(57) **Abstract**

Provided are a solar cell apparatus and a method of manufacturing the same. The solar cell apparatus includes a substrate, a first cell disposed on the substrate, and a second cell disposed on the substrate, the second cell being adjacent to the first cell. The first cell includes a plurality of first active areas and a plurality of first transmitting areas which are alternately disposed with respect to each other. The second cell includes a plurality of second active areas and a plurality of second transmitting areas which are alternately disposed with respect to each other. The first active areas are adjacent to the second transmitting areas, respectively.

## Description

### BACKGROUND

Embodiments relate to a solar cell apparatus and a method of manufacturing the same.

Solar cell apparatuses converting solar energy into electrical energy using a photoelectric conversion effect are being widely used as units for obtaining nonpolluting energy contributing to earth's environmental preservation.

As the photoelectric conversion efficient of solar cells is improved, various photovoltaic systems including the solar cell apparatus are being installed on outer walls of business buildings as well as residential spaces.

That is, building integrated photovoltaic (BIPV) technologies in which photovoltaics are used as exterior finishing materials of the architecture are in the spotlight.

Performance required for the exterior finishing material and architecture power supply performance required for self-power generation are required in the BIPV technologies.

Thus, light transmittance and light efficiency of the solar cells are becoming the main issue.

### SUMMARY

Embodiments provide is a solar cell apparatus having improved light transmittance and electrical properties and a method of manufacturing the same.

In one embodiment, a solar cell apparatus includes: a substrate; a first cell disposed on the substrate; and a second cell disposed on the substrate, the second cell being adjacent to the first cell, wherein the first cell includes a plurality of first active areas and a plurality of first transmitting areas which are alternately disposed with respect to each other, the second cell includes a plurality of second active areas and a plurality of second transmitting areas which are alternately disposed with respect to each other, and the first active areas are adjacent to the second transmitting areas, respectively.

In another embodiment, a solar cell apparatus includes: a substrate; and a solar cell layer disposed on the substrate, wherein the solar cell layer includes a plurality of active areas and a plurality of transmitting areas which are alternately disposed with respect to each other, and each of the transmitting areas includes: a lower transparent electrode disposed on the substrate; a transparent insulation layer disposed on the lower transparent electrode; and an upper transparent electrode disposed on the transparent insulation layer.

In further another embodiment, a method of manufacturing a solar cell apparatus includes: forming a back electrode layer on a substrate; forming a light absorption layer on the back electrode layer; patterning the back electrode layer and the light absorption layer to form a plurality of transmitting grooves; forming a lower transparent electrode inside each of the transmitting grooves; forming a transparent insulation layer on the lower transparent electrode; and forming a front electrode layer on the light absorption layer and the transparent insulation layer.

In still further another embodiment, a solar cell apparatus includes: a substrate; a first cell disposed on the substrate; and a second cell disposed on the substrate, the second cell being adjacent to the first cell, wherein the first cell includes a plurality of first active areas and a plurality of first transmitting areas which are alternately disposed with respect to each other, the second cell includes a plurality of second active areas and a plurality of second transmitting areas which are alternately disposed with respect to each other, and the first active areas are connected to the second active areas.

In even further another embodiment, a method of manufacturing a solar cell apparatus includes: forming a back electrode layer on a substrate; forming a light absorption layer on the back electrode layer; forming a front electrode layer on the light absorption layer; and patterning the back electrode layer, the light absorption layer, and the front electrode layer to form a plurality of active areas and a plurality of transmitting areas, wherein the active areas are adjacent and connected to each other, and the transmitting areas are spaced from each other.

The details of one or more embodiments are set forth in the accompanying drawings and the description below. Other features will be apparent from the description and drawings, and from the claims.

### BRIEF DESCRIPTION OF THE DRAWINGS

Fig. 1 is a plan view of a solar cell panel according to a first embodiment.

Fig. 2 is a sectional view taken along line X-X' of Fig. 1.

Fig. 3 is a sectional view taken along line Y-Y' of Fig. 1.

Fig. 4 is a view illustrating a current flow of the solar cell panel according to the first embodiment.

Figs. 5 to 16 are sectional views illustrating a process of manufacturing the solar cell panel according to the first embodiment.

Figs. 17 and 18 are plan views of a solar cell panel according to a second embodiment.

Fig. 19 is a sectional view taken along line N1-N2 of Fig. 17.

Fig. 20 is a sectional view taken along line L1-L2 of Fig. 17.

Fig. 21 is a sectional view taken along line M1-M2 of Fig. 17.

Figs. 22 to 36 are sectional views illustrating a process of manufacturing the solar cell panel according to the second embodiment.

### DETAILED DESCRIPTION OF THE EMBODIMENTS

In the descriptions of embodiments, it will be understood that when a substrate, a layer, a film or an electrode is referred to as being 'on' or 'under' another substrate, layer, film or electrode, it can be directly on or under another layer or substrate, or intervening layers may also be present. Further, the reference about 'on' and 'under' each component layer will be made on the basis of drawings. In addition, the sizes of elements and the relative sizes between elements may be exaggerated for further understanding of the present disclosure.

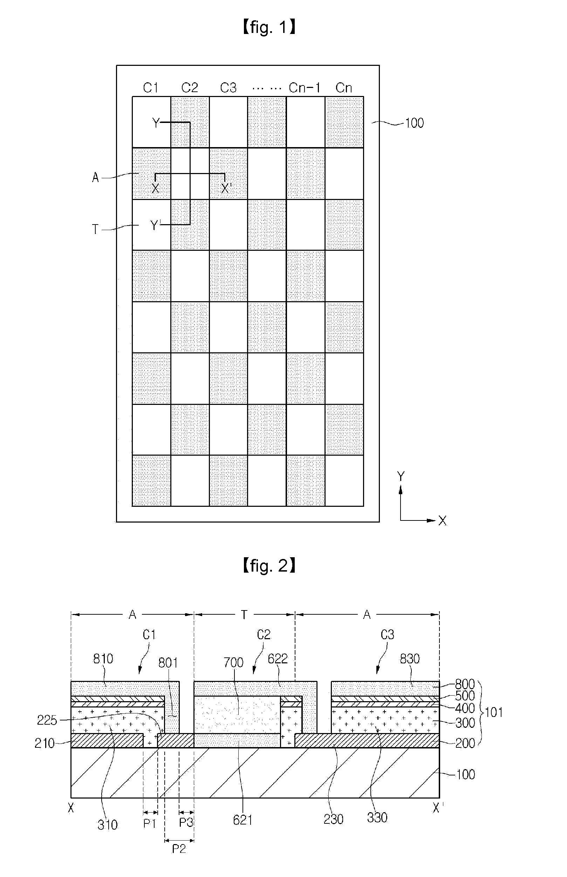

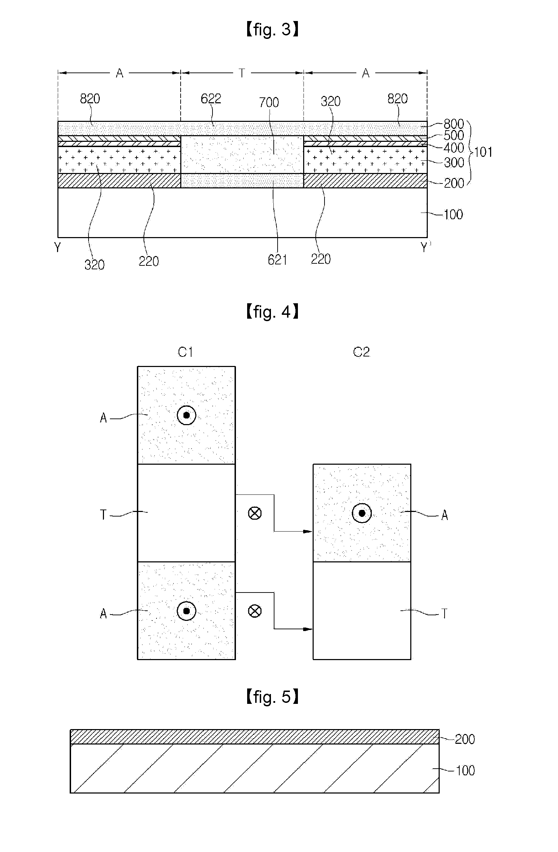

Fig. 1 is a schematic plan view of a solar cell panel according to a first embodiment. Fig. 2 is a sectional view taken along line X-X' of Fig. 1. Fig. 3 is a sectional view taken along line Y-Y' of Fig. 1. Fig. 4 is a view illustrating a current flow of the solar cell panel according to the first embodiment.

Referring to Figs. 1 to 4, a solar cell panel according to the first embodiment includes a substrate 100 and a solar cell layer 101.

The substrate 100 is transparent and an insulator. The substrate 100 has a plate shape. The substrate 100 may be a glass substrate 100 or a plastic substrate 100. In detail, the substrate 100 may be a soda lime glass substrate 100.

The solar cell layer 101 is disposed on the substrate 100. The solar cell layer 101 converts light incident from the outside into electric energy. Also, the solar cell layer 101 may transmit a portion of light incident from the outside.

The solar cell layer 101 includes a plurality of active areas A and a plurality of transmitting areas T. The active areas A and the transmitting areas T may be disposed in a mosaic shape. That is, when viewed in plan, the solar cell layer 101 may have a mosaic shape by the active areas A and the transmitting areas T.

Alternatively, when viewed in a plan, the active areas A and the transmitting areas T may have a rectangular shape. Also, the active areas A and the transmitting areas T may be alternately disposed.

Also, the active areas A are disposed in a diagonal direction with respect to each other and adjacent to the transmitting areas T. That is, the active areas A are surrounded by the transmitting areas T, and the transmitting areas T are surrounded by the active areas A.

The solar cell layer 101 are divided into a plurality of solar cells C1,..., and, Cn. The solar cells C1,..., and, Cn may include a first cell C1, a second cell C2, and a third cell C3.

The active areas A and the transmitting areas T may be alternately disposed in a line in the first, second, and third cells C1, C2, and C3. Here, the active areas A of the first cell C1 may be adjacent to the transmitting areas T of the second cell C2.

That is, the active areas A and the transmitting areas T may have a mosaic shape or tile shape in the first, second, and third cells C1, C2, and C3.

For example, the transmitting areas T may be disposed about one active area A in the second cell C2. Also, the active areas A may be disposed about one transmitting area T in the second cell C2.

Also, each of the active areas A may have the same size as that of each of the transmitting areas T. However, the present disclosure is not limited thereto. For example, each of the transmitting areas T may be adjusted in position, size, and shape to control light transmittance.

In the solar cell layer 101, the active areas A and the transmitting areas T may be disposed in the mosaic shape to improve power generation efficiency and light transmittance of the solar cell panel.

Also, it may prevent a leakage current from occurring among the cells C1,...and, Cn by a transparent insulation layer 700.

Referring to Fig. 2, the transmitting area T of the second cell C2 may be disposed between the active areas A of the first and second cells C1 and C3.

Also, the solar cell layer 101 includes a back electrode layer 200, a light absorption layer 300, a buffer layer 400, a high-resistance buffer layer 500, and a front electrode layer 800, which are successively stacked on the substrate 100.

The back electrode layer 200 is divided into a plurality of back electrodes 210, 220,... by a plurality of first through holes P1. That is, the first through holes P1 may selectively expose the substrate 100 and define the back electrodes 210, 220,... The back electrodes 210, 220,... are disposed on the active areas A, respectively.

The light absorption layer 300 is divided into a plurality of light absorption parts 310, 320,... by a plurality of second through holes P2. That is, the second through holes P2 may selectively expose a top surface of the back electrode layer 200 and define the light absorption parts 310, 320,... The light absorption parts 310, 320,... are disposed on the active areas A, respectively.

The front electrode layer 800 is divided into a plurality of front electrodes 810, 820,... and a plurality of upper transparent electrodes 622 by a plurality of third through holes P3. That is, the third through holes P3 may selectively expose a top surface of the back electrode layer 200 and define the front electrodes 810, 820,... and the upper transparent electrodes 622. The front electrodes 810, 820,... are disposed on the active areas A, respectively. Also, the upper transparent electrodes 622 are disposed on the transmitting areas T, respectively.

The solar cell layer 101 are divided into the plurality of cells C1,..., and, Cn by the third through holes P3. Also, the third through holes P3 are defined among the cells C1,..., and, Cn, respectively. Also, each of the third through holes P3 is defined between the active area A and the transmitting area T.

Each of the active areas A includes one back electrode, one light absorption part, the buffer layer 400, the high-resistance buffer layer 500, and one front electrode, which are successively stacked. The light absorption parts 310, 320,... and the front electrodes 810, 820,... may be PN-junctioned with each other, and the active areas A may generate photoelectrons by incident light.

Also, each of the transmitting areas T includes a lower transparent electrode 621 disposed on the substrate 100, the transparent insulation layer 700 disposed on the lower transparent electrode 621, and the upper transparent electrode 622 disposed on the transparent insulation layer 700.

That is, since the substrate 100, the lower transparent electrode 621, the transparent insulation layer 700, and the upper transparent electrode 622 are transparent, the transmitting areas T may transmit light. For example, each of the lower transparent electrode 621 and the upper transparent electrode 622 may be formed of a transparent conductive material. The transparent insulation layer 700 may be formed of a transparent amorphous resin or a photoresist.

Also, the lower transparent electrode 621 is connected to the front electrode of one adjacent active area A through a back electrode pattern 225. The upper transparent electrode 622 is connected to the back electrode of the other adjacent active area A.

Referring to Fig. 3, the lower transparent electrode 621 may be connected to the back electrode 220 of the adjacent active area A. Also, the upper transparent electrode 622 may be integrated with the front electrode 820 of the adjacent active area A.

For example, each of the active areas A of the first cell C1 includes a first back electrode 210, a first light absorption part 310, the buffer layer 400, the high-resistance buffer layer 500, and a first front electrode 810, which are successively stacked. Also, each of the transmitting areas T of the first cell C1 includes a first lower transparent electrode, a first transparent insulation layer, and a first upper transparent electrode, which are successively stacked.

The first back electrode 210 is connected to the first lower transparent electrode. That is, the first back electrode 210 directly contacts the first lower transparent electrode and also is electrically connected to the first lower transparent electrode. Also, the first front electrode 810 and the first upper transparent electrode are integrated with each other.

Each of the active areas A of the second cell C2 includes a second back electrode 220, a second light absorption part 320, the buffer layer 400, the high-resistance buffer layer 500, and a second front electrode 820, which are successively stacked. Also, each of the transmitting areas T of the second cell C2 includes a second lower transparent electrode 621, a second transparent insulation layer 700, and a second upper transparent electrode 622, which are successively stacked.

Also, the active areas A of the second cell C2 are adjacent to the transmitting areas T of the first cell C1. The transmitting areas T of the second cell C2 are adjacent to the active areas A of the first cell C1. That is, the active areas A of the first cell C1 and the active areas A of the second cell C2 are disposed in a diagonal direction with respect to each other. Also, the active areas A of the first cell C1 and the active areas A of the second cell C2 are mutually disposed in a zigzag form.

The second back electrode 220 is connected to the second lower transparent electrode 621. That is, the second back electrode 220 directly contacts the second lower transparent electrode 621 and also is electrically connected to the second lower transparent electrode 621. Also, the second front electrode 820 and the second upper transparent electrode 622 are integrated with each other.

Also, the first front electrode 810 is connected to the second lower transparent electrode 621 through a connection line 801. In detail, the first front electrode 810 is connected to the second back electrode 220 through the second lower transparent electrode 621. Also, the first front electrode 810 is connected to the second back electrode 220 through the first upper transparent electrode.

Each of the active areas A of the third cell C3 includes a third back electrode 230, a third light absorption part 330, the buffer layer 400, the high-resistance buffer layer 500, and a third front electrode 830, which are successively stacked. Also, each of the transmitting areas T of the third cell C3 includes a third lower transparent electrode, a third transparent insulation layer 700, and a third upper transparent electrode, which are successively stacked.

Also, the active areas A of the third cell C3 are adjacent to the transmitting areas T of the second cell C2. The transmitting areas T of the third cell C3 are adjacent to the active areas A of the second cell C2. That is, the active areas A of the second cell C2 and the active areas A of the third cell C3 are disposed in a diagonal direction with respect to each other. Also, the active areas A of the second cell C2 and the active areas A of the third cell C3 are mutually disposed in a zigzag form.

The third back electrode 230 is connected to the third lower transparent electrode. That is, the third back electrode 230 directly contacts the third lower transparent electrode and also is electrically connected to the third lower transparent electrode. Also, the third front electrode 830 and the third upper transparent electrode are integrated with each other.

The second front electrode 820 is connected to the third lower transparent electrode. In detail, the second front electrode 820 is connected to the third back electrode 230 through the third lower transparent electrode. Also, the second upper transparent electrode 622 is connected to the third back electrode 230. That is, the second front electrode 820 is connected to the third back electrode 230 through the second upper transparent electrode 622.

A photo-charge generated in the first cell C1 is transferred into the back electrode pattern 225 and the second lower transparent electrode 621 of the second cell C2 through the connection line 801. Also, the photo-charge transferred into the second lower transparent electrode 621 is transferred into the second back electrode 220.

The connection line 801 extending from the second upper transparent electrode 622 may be electrically connected to the third back electrode 230 through the second through holes P2. Also, the connection line 801 and the third front electrode 830 are separated by the third through hole P3. A portion of the connection line 801 may be removed and a portion of the third back electrode 230 may be exposed through the third through hole P3.

As shown in Fig. 3, the transmitting area T is disposed between the active areas A. Also, each of the active areas A of the second cell C2 includes the second back electrode 220, the second light absorption part 320, the buffer layer 400, the high-resistance buffer layer 500, and the second front electrode 820, which are successively stacked on the substrate 100.

Each of the transmitting areas T of the second cell C2 includes the second lower transparent electrode 621, the transparent insulation layer 700, and the second upper transparent electrode 622, which are successively stacked on the substrate 100. The second back electrode 220 may be electrically and physically connected to the second lower transparent electrode 621. Also, the second front electrode 820 is electrically and physically connected to the second upper transparent electrode 622.

Thus, the photo-charge transferred through the second lower transparent electrode 621 may be transferred into the second back electrodes 220 disposed on both sides of the lower transparent electrode 621 in the first cell C1. Also, the photo-charge transferred into the second back electrode 220 may be transferred into the third cell C3 through the second front electrode 820 and the second upper transparent electrode 622.

The front electrode layer 800 may be disposed on the high-resistance buffer layer 500 and the transparent insulation layer 700. That is, the second front electrode 820 and the second upper transparent electrode 622 are integrated with each other on an upper entire surface corresponding to the second cell C2.

The second cell C2 has a structure in which the active areas A and the transmitting areas T are alternately disposed in a line. That is, the active areas A and the transmitting areas T are alternately disposed in the second cell C2. This structure may be applied to the first and third cells C1 and C3.

Thus, the active areas A and the transmitting areas T disposed on the substrate 100 may have a lattice shape in which the active areas A and the transmitting areas T are alternately disposed in horizontal and vertical directions.

For example, as shown in Fig. 1, the horizontal direction represents an X-X' direction in which the first to third cells C1, C2, and C3 are successively disposed, and the vertical direction represents a Y-Y' direction corresponding to each cell.

The front electrode layer 800 is separated by each cell in the horizontal direction. Also, the front electrode layer 800 extends on the entire surface in the vertical direction, and unit cells thereof may be connected to each other in series.

Specifically, the front electrode layers 800 of the first to third cells C1 to C3 may be spaced a minimum distance from each other through the third through holes P3, respectively. Also, since the front electrode layer 800 has the extending shape on each of the first to third cells C1, C2, and C3, current losses may be minimized and output current may be improved.

Fig. 4 is a view illustrating a movement path of the photo-charge of the solar cell illustrated in Figs. 1 to 3. A reference symbol ⊙ illustrated in Fig. 4 shows a movement in an upper direction, and a reference symbol ⓧ shows a movement in a lower direction.

Referring to Fig. 4, photo-charges generated in the active areas A of the first cell C1 are transferred into the adjacent second cell C2 through the front electrode layer 800 and the connection line 801.

Here, since the active areas A of the first cell C1 and the transmitting area T of the second cell C2 are adjacent to each other, the photo-charges are transferred into the second back electrode pattern 225 and the lower transparent electrode 621 of the second cell C2.

Also, the photo-charges transferred into the lower transparent electrode 621 of the second cell C2 may be transferred into the second back electrodes 220 disposed on both sides of the lower transparent electrode 621.

As described above, the regular transmitting areas T may be formed through the mosaic shape, a mesh shape, or the tile shape to minimize the losses of the output current.

Specifically, a portion of the transmitting area T may be removed in the cell to transmit light, thereby expanding the transmitting area. Since the back electrodes 210, 220,... and the lower transparent electrodes 621 are alternately and repeatedly disposed at a lower portion of the solar cell layer 101 and the front electrode layer 800 is disposed at an upper portion of the solar cell layer 101, the current losses may be minimized.

Also, each of the cells C1,..., and, Cn may be changed in width and length and the transmitting area T may be adjusted in size to improve an outer appearance.

In the solar cell panel according to the first embodiment, the active areas A and the transmitting areas T are adjacent to each other. Thus, the active areas A and the transmitting areas T may be disposed in the mosaic shape.

Thus, a distance between the active areas A may be closer to reduce the electrical losses occurring when the distance between the active areas A is away from each other. Specifically, the upper transparent electrode 622 and the lower transparent electrode 621 may be disposed on each of the transmitting areas T to connect the active areas A to each other. Here, since a path of a current flowing through the upper transparent electrode 622 and the lower transparent electrode 621 is short, the solar cell panel according to the current embodiment may have improved electrical properties.

The back electrodes 210, 220,... of the active areas A may be connected to each other by the lower transparent electrode 621, and the front electrodes 810, 820,... of the active areas A may be connected to each other by the upper transparent electrode 622. Thus, in the solar cell panel according to the current embodiment, a resistance between the active areas A may be reduced to improve the electrical properties.

Also, in the solar cell panel according to the current embodiment, desired portions of the light absorption layer 300 and the back electrode layer 200 may be removed to form the transmitting area T. Thus, in the solar cell panel according to the current embodiment, the transmitting area T may be disposed in a desired position to realize improved outer appearance and light transmittance.

Also, the solar cell panel according to the current embodiment may realize a color on the transparent insulation layer 700 disposed on the transmitting area T.

Figs. 5 to 15 are sectional views illustrating a process of manufacturing a solar cell according to an embodiment. This manufacturing process according to the current embodiment will be described with reference to the above-described solar cell panel. This manufacturing process and the descriptions with respect to the foregoing solar cell panel may be essentially applied to each other.

Referring to Fig. 5, a back electrode layer 200 is formed on a substrate 100.

The substrate 100 may be formed of glass. Also, the substrate 100 may include a ceramic substrate, a metal substrate, and a polymer substrate. For example, the glass substrate may be formed of soda lime glass or high strained point soda glass. The metal substrate may include a substrate formed of a stainless steel or titanium. The polymer substrate may be formed of polyimide.

The substrate 100 may be transparent. The substrate 100 may be rigid or flexible.

The back electrode layer 200 is formed of a conductor such as a metal. Since the back electrode layer 200 is formed of a metal, series resistance properties may be improved to improve conductivity.

For example, the back electrode layer 200 may be formed using a molybdenum (Mo) target through a sputtering process.

This is done because of high conductivity of Mo, ohmic contact with a light absorption layer 300, and high-temperature stability under Se atmosphere.

A Mo thin film that is the back electrode layer 200 should have a low specific resistance as an electrode and also superior adhesion with the substrate 100 so that it prevent exfoliation from occurring by a difference of a thermal expansion coefficient.

However, the present disclosure is not limited thereto. For example, the back electrode layer 200 may be formed of Mo doped with Na ions.

Although not shown, the back electrode layer 200 may include at least one layer. When the back electrode layer 200 includes a plurality of layers, the layers constituting the back electrode layer 200 may be formed of materials different from each other.

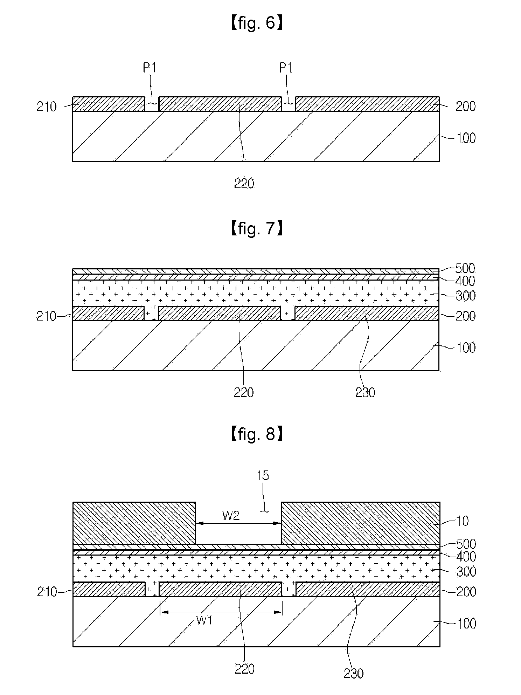

Referring to Fig. 6, first through holes P1 are defined in the back electrode layer 200. Also, the back electrode layer 200 includes a plurality of back electrodes 210, 220, 230,... A surface of the substrate 100 may be selectively exposed through the first through holes P1. For example, the first through holes P1 may be patterned through a laser process or a mechanical process.

The back electrodes 210, 220,... may be disposed in a stripe shape or a matrix shape by the first through holes P1 to correspond to each cell.

The plurality of back electrodes 210, 220,... may include a first back electrode 210, a second back electrode 220, and a third electrode 230.

For example, the first back electrode 210 is included in a first cell C1, the second back electrode 220 is included in a second cell C2, and the third back electrode 230 is included in a third cell C3.

Referring to Fig. 7, the light absorption layer 300 is formed on the first to third back electrodes 210, 220, and 230 to gap-fill the first through holes P1.

The light absorption layer 300 is formed of a group I-III-VI-based compound.

In detail, the absorption layer 300 is formed of a Cu(In, Ga)Se2-based (CIGS-based) compound.

On the other hand, the light absorption layer 300 may be formed of a CuInSe2-based (CIS-based) compound or a Cu, Ga, Se2-based (CGS-based) compound.

For example, the light absorption layer 300 is formed using a Cu target, an In target, and a Gs target. A CIG-based metal precursor layer is formed on the back electrode layer 200.

Thereafter, the metal precursor layer reacts with Se through a selenization process to form a CIGS-based light absorption layer.

Also, a co-evaporation process using Cu, In, Ga, and Se may be performed form the light absorption layer 300.

The light absorption layer 300 receive external light to convert the light into electrical energy. The light absorption layer 300 generates a photoelectron-motive force by a photoelectric effect.

A buffer layer 400 and a high-resistance buffer layer 500 are formed on the light absorption layer 300.

At least one or more buffer layers 400 may be formed on the light absorption layer 300. Cadmium sulfide (CdS) may be stacked using a chemical bath deposition (CBD) to form the buffer layer 400.

Here, the buffer layer 400 may be an N-type semiconductor layer, and the light absorption layer 300 may be a P-type semiconductor layer. Thus, the light absorption layer 300 and the buffer layer 400 are PN-junctioned with each other.

A sputtering process may be performed on the high-resistance buffer layer 500 using ZnO as a target to further form a ZnO layer on the CdS.

The high-resistance buffer layer 500 may be formed as a transparent electrode layer on the buffer layer 400.

For example, the high-resistance buffer layer 500 may be formed of one of ITO, ZnO, and i-ZnO.

The buffer layer 400 and the high-resistance buffer layer 500 are disposed between the light absorption layer 300 and a front electrode layer 800 that will be formed later.

That is, since each of the light absorption layer 300 and the front electrode layer 800 has a large difference between an energy band gap and a lattice constant, the buffer layer 400 and the high-resistance buffer layer 500 having about middle band gap values of the band gap values of the light absorption layer 300 and the front electrode layer 800 may be inserted to realize good junction.

Although the two buffer layers 400 and 500 are formed on the light absorption layer 300 in the current embodiment, the present disclosure is not limited thereto. For example, only one buffer layer may be formed on the light absorption layer 300.

Referring to Fig. 8, a mask 10 is formed on the high-resistance buffer layer 500.

The mask 10 may selectively expose a surface of the high-resistance buffer layer 500 corresponding to the second back electrode 220. That is, the mask 10 includes a plurality of openings 15. The openings 15 may define areas on which transmitting areas T will be formed.

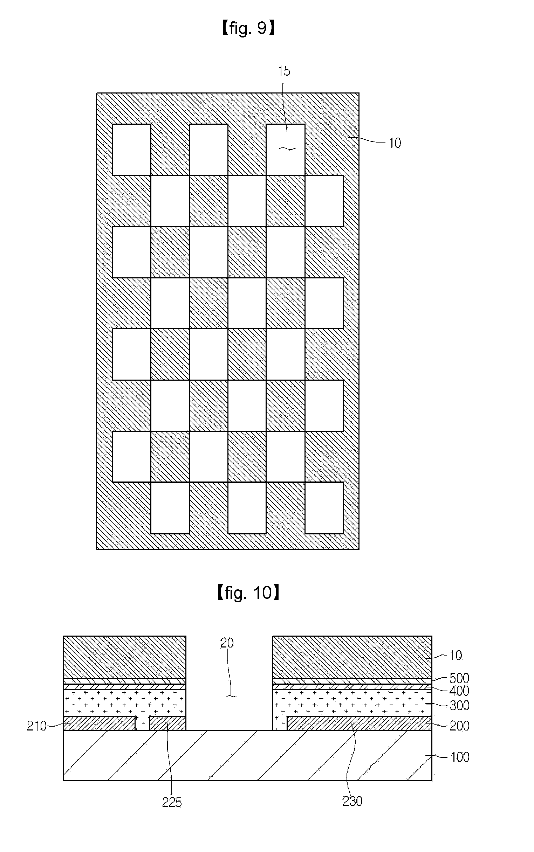

Referring to Fig. 9, the mask 10 may have a mosaic shape in which an exposure area and a non-exposure area are alternately disposed. That is, the openings 15 may be alternately formed in a horizontal direction. Also, the openings 15 may be alternately formed in a vertical direction.

That is, the openings 15 may have a mosaic shape. Thus, the area on which the transmitting areas T are formed by the mask 10 may be defined in the mosaic shape.

A photoresist layer may be coated on the high-resistance buffer layer 500 and then a selective exposing process may be performed to form the mask 10.

The mask 10 may cover the surface of the high-resistance buffer layer 500 corresponding to the first through holes P1. Specifically, the mask 10 may cover the surface of the high-resistance buffer layer 500 adjacent to the first back electrode 210 and corresponding to an edge area of the second back electrode 220.

For example, the second back electrode 220 may have a first width W1, and each of the openings 15 of the mask 10 may have a second width W2 less than the first width W1.

Referring to Fig. 10, the second back electrode 220, the light absorption layer 300, the buffer layer 400, and the high-resistance buffer layer 500 are patterned to form transmitting grooves 20. An etching process may be performed using the mask 10 as an etch mask to form the transmitting grooves 20.

For example, a wet or dry etching process may be performed to remove the high-resistance buffer layer 500, the buffer layer 400, the light absorption layer 300, and the second back electrode 220 corresponding to the openings of the mask 10, thereby forming the transmitting grooves 20. Thus, a top surface of the substrate 100 may be exposed through the transmitting grooves 20.

Each of the transmitting grooves 20 may have the second width W2 less than that of the second back electrode 220. Thus, a portion of the second back electrode 220 adjacent to the first back electrode 210 may remain by the transmitting grooves 20 to form a second back electrode pattern 225.

A plurality of active areas A and a plurality of transmitting areas T are defined by the transmitting grooves 20. Thus, a first cell C1, a second cell C2, and a third cell C3 may be defined. That is, the active areas A and the transmitting areas T may be alternately disposed on each of the first, second, and third cells C1, C2, and C3.

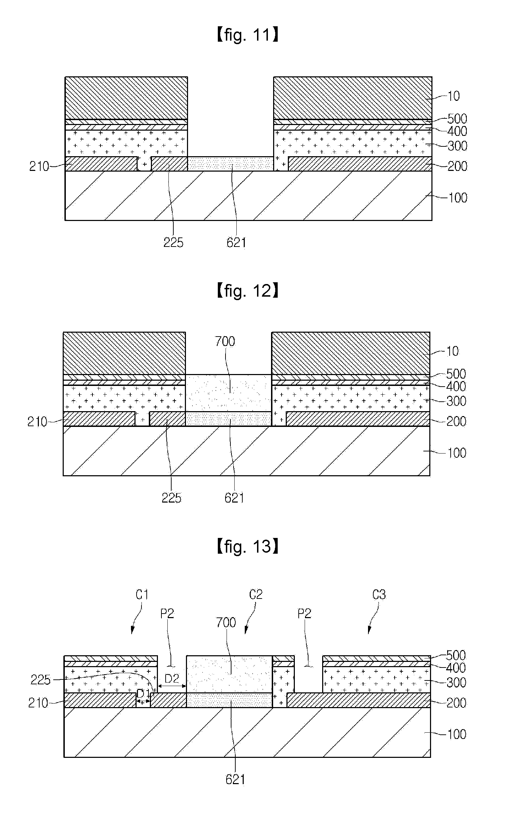

Referring to Fig. 11, a transparent conductive material is stacked on a bottom surface of each of the transmitting grooves 20 to form a lower transparent electrode 621.

The lower transparent electrode 621 may be formed on the substrate 100 corresponding to the bottom surface of each of the transmitting grooves 20. Specifically, since the lower transparent electrode 621 is formed through a deposition process using the mask 10, the lower transparent electrode 621 may be selectively formed on only the bottom surface of each of the transmitting grooves 20.

Thus, the lower transparent electrode 621 may be electrically connected to the second back electrode pattern 225.

The lower transparent electrode 621 may be formed of Zn-based oxide containing impurities such as Al, Al₂O₃, Mg, and Ga or indium tin oxide (ITO).

For example, a sputtering process may be performed to form ZnO doped with aluminum or alumina, thereby forming the lower transparent electrode 621 having a low resistance.

The lower transparent electrode 621 may have the same thickness as that of the back electrode pattern 225. Also, the lower transparent electrode 621 may have a low sheet resistance of about 10 Ω to about Ω and light transmittance of about 80% to about 90%.

Thus, the lower transparent electrode 621 may transmit light.

Referring to Fig. 12, a transparent insulation layer 700 is formed on the lower transparent electrode 621 to gap-fill the transmitting grooves 20.

The transparent insulation layer 700 may be formed between the first cell C1 and the third cell C3. The first cell C1 and the third cell C3 may be separated from each other by the transparent insulation layer 700.

The transparent insulation layer 700 may have the same height as that of the high-resistance buffer layer 500 corresponding to the first and third cells C1 and C3.

The transparent insulation layer 700 may be formed of a transparent insulation material.

The transparent insulation material may be a material having heat resistance of about 100°C to about 200°C, light transmittance of about 90% to about 100%, strong alkaline resistance, solar resistance, and insulating resistance.

For example, the transparent insulation layer 700 may be formed of one of poly methyl methacrylate (PMMA) and acrylonitrile which are transparent amorphous resins and SAN, poly cabornate (PC), transparent acrylonitrile butadiene styrene (ABS), polyethylene terephtalate (PET), ultra high molecular weight (U-HMW) ployethylene, methyl cellulose (MC), poly oxy methylene (POM), polytetrafluoroethylene (PTEE), polypropylene oxide (PPO), and polyurethane (PUR) which are copolymers of styrene.

Also, the transparent insulation layer 700 may be formed of a positive or negative photoresist.

The transparent insulation layer 700 may be selectively formed within the transmitting grooves 20 through a deposition, thermal absorption, injection, or filling process. Also, when the transparent insulation layer 700 is formed, a color may be added to the transparent insulation material to form color transmitting areas T.

The active areas A and the transmitting areas T are defined on the substrate 100 by the transparent insulation layer 700. Areas surrounding the transparent insulation layer 700 are defined as the active areas A. That is, light incident into the active area A of the first cell C1 and the active area A of the third cell C3 disposed on both sides of the transparent insulation layer 700 is converted into electrical energy.

Since the transmitting area T on which the transparent insulation layer 700 is disposed is an inactive area, the incident light is not converted into electrical energy. Here, since the transparent insulation layer 700 is transparent, the incident light may be transmitted.

Thereafter, an ashing process may be performed to remove the mask 10.

Referring to Fig. 13, a plurality of second through holes P2 passing through the high-resistance buffer layer 500, the buffer layer 400, and the light absorption layer 300 are formed. The second through holes P2 are formed through a mechanical process or a laser process to expose the back electrodes 210, 220,... corresponding to each cell.

The second through holes P2 may be disposed adjacent to the first through holes P1. Each of the second through holes P2 may have a width greater than that of each of the first through holes P1. For example, each of the first through holes P1 may have a first width D1, and each of the second through holes P2 may have a second width D2 greater than that of the first width D1. That is, as shown in Fig. 13, top surfaces of the second back electrode pattern and the third back electrode 230 may be selectively exposed by the second through holes P2.

Specifically, the second through holes P2 exposing the second back electrode pattern 225 may be adjacent to a sidewall of the transparent insulation layer 700 or may expose the sidewall of the transparent insulation layer 700.

On the other hand, a portion of the transparent insulation layer 700 may be patterned to expose a portion of the lower transparent electrode 621 through the second through holes P2 exposing the second back electrode pattern 225.

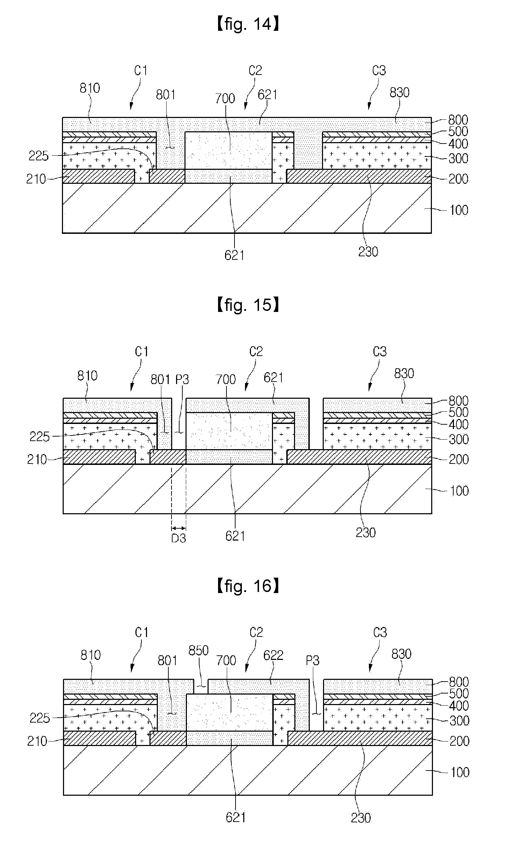

Referring to Fig. 14, a transparent conductive material is stacked on the high-resistance buffer layer 500 including the second through holes P2 to form a front electrode layer 800.

When the front electrode layer 800 is formed, the transparent conductive material may be inserted into the second through holes P2 to form a connection line 801. Thus, the second back electrode pattern 225 and the third back electrode 230 may be electrically connected to the front electrode layer 800 by the connection line 801.

The front electrode layer 800 may be formed of the same material as that of the lower transparent electrode 621. The front electrode layer 800 may be formed of Zn-based oxide containing impurities such as Al, Al₂O₃, Mg, and Ga or indium tin oxide (ITO).

For example, a sputtering process may be performed to form ZnO doped with aluminum or alumina, thereby forming the front electrode layer 800 having a low resistance.

That is, the front electrode layer 800 is a window layer which is PN-junctioned with the light absorption layer 300. Thus, since the front electrode layer 800 serves as a transparent electrode of a front surface of the solar cell, the front electrode layer 800 may be formed of ZnO having high light transmittance and electrical conductivity.

Referring to Fig. 15, a third through holes P3 passing through the front electrode layer 800 and the connection line 801 are formed. The second back electrode pattern 225 and the third back electrode 230 may be selectively exposed through the third through holes P3.

The front electrode layer 800 may be divided into unit cells through the third through holes P3. The connection line 801 within the second through holes P2 may be selectively removed to form the third through holes P3.

Sidewalls of the transparent insulation layer 700 and the connection line 801 extending from the first cell C1 may be exposed through the third through holes P3 between the first cell C1 and the second cell C2.

Sidewalls of the connection line 801 extending from the second cell C2 and a thin film layer of a top surface of the third back electrode 230 may be exposed through the third through holes P3 between the second cell C2 and the third cell C3.

For example, each of the third through holes P3 may have a width D3 less than the second width D2.

The third through holes P3 may be formed using a mechanical device such as a tip, or a laser process.

Thus, the first, second, and third cells C1, C2, and C3 are separated from each other by the third through holes P3. Here, the first, second, and third cells C1, C2, and C3 may be electrically connected to each other by the connection line 801.

Fig. 16 illustrates a state in which the first and second cells C1 and C2 are electrically separated from each other by an isolation pattern 850.

That is, a portion of the front electrode layer 800 corresponding to the second cell C2 is removed to form the isolation pattern 850.

The isolation pattern 850 may selectively expose a top surface of the transparent insulation layer 700. Thus, the front electrode layers 800 of the first and second cells C1 and C2 may be separated from each other by the isolation pattern 850.

Here, the connection line 801 extending from the first cell C1 may be electrically connected to the second back electrode pattern 225 through the second through holes P2.

Since a contact area between the second back electrode pattern 225 and the connection line 801 may be expanded, the electrical properties may be improved.

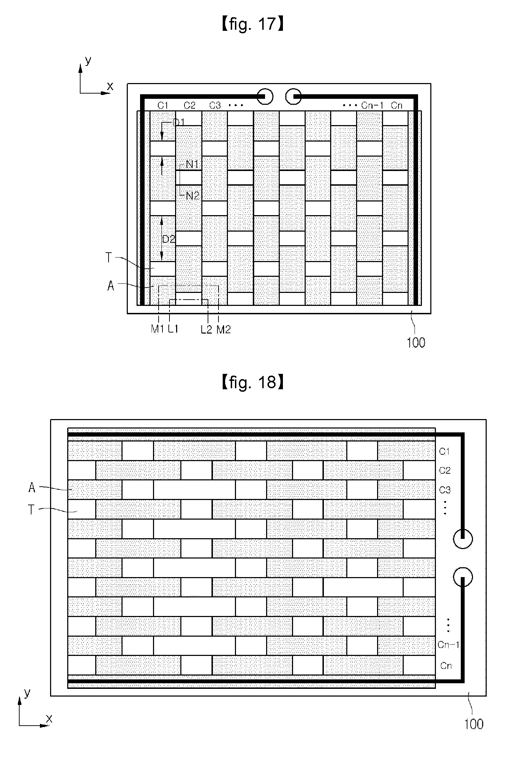

Figs. 17 and 18 are plan views of a solar cell panel according to a second embodiment.

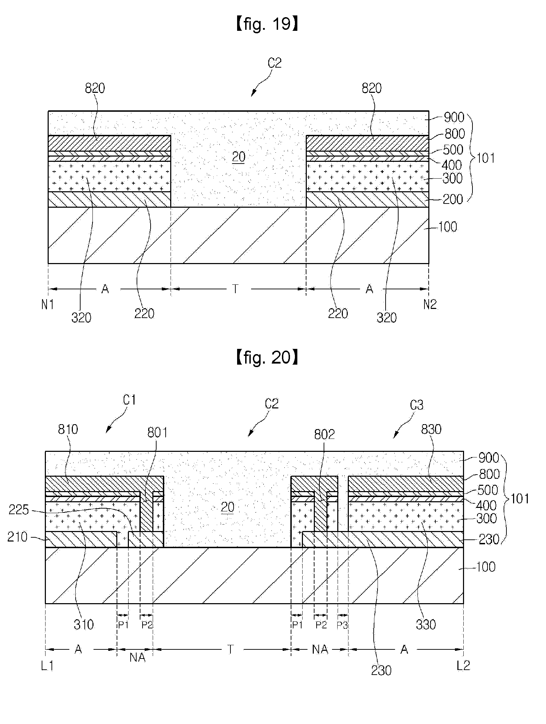

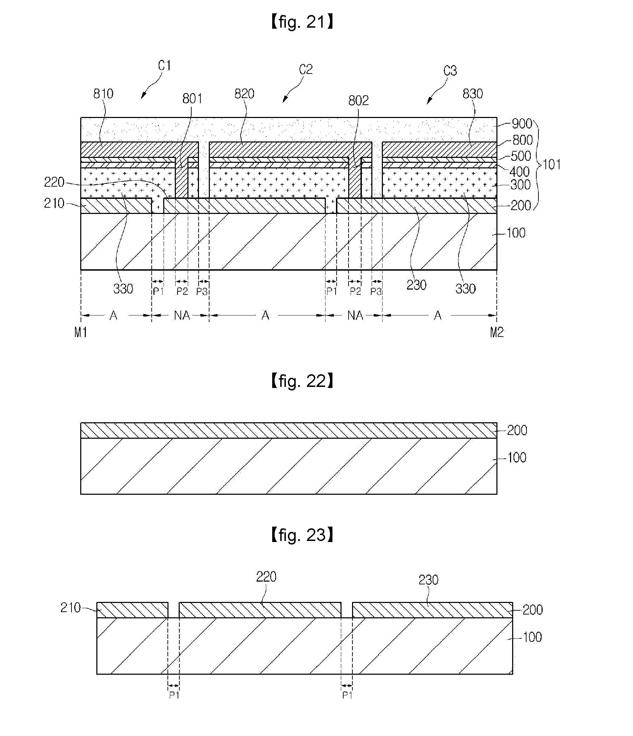

Specifically, Fig. 17 illustrates solar cells extending in a vertical direction, and Fig. 18 illustrates solar cells extending in a horizontal direction. Fig. 19 is a sectional view taken along line N1-N2 of Fig. 17. Fig. 20 is a sectional view taken along line L1-L2 of Fig. 17. Fig. 21 is a sectional view taken along line M1-M2 of Fig. 17. Hereinafter, the current embodiment will be described in detail with reference to Fig. 17.

The above-described solar cell panel and the method of manufacturing the same according to the first embodiment may be essentially applied to the current embodiment except for modified portions.

Referring to Figs. 17 to 21, a solar cell panel according to the second embodiment includes a substrate 100 and a solar cell layer 101.

The substrate 100 is transparent and an insulator. The substrate 100 has a plate shape. The substrate 100 may be a glass substrate 100 or a plastic substrate 100. In detail, the substrate 100 may be a soda lime glass substrate 100.

The solar cell layer 101 is disposed on the substrate 100. The solar cell layer 101 converts light incident from the outside into electric energy. Also, the solar cell layer 101 may transmit a portion of light incident from the outside.

The solar cell layer 101 includes a plurality of active areas A and a plurality of transmitting areas T. The active areas A and the transmitting areas T may be disposed in a mosaic shape. That is, when viewed in plan, the solar cell layer 101 may have a mosaic shape by the active areas A and the transmitting areas T.

Alternatively, when viewed in a plan, the active areas A and the transmitting areas T may have a rectangular shape. Also, the active areas A and the transmitting areas T may be alternately disposed.

Also, the active areas A are disposed in a diagonal direction and adjacent to the transmitting areas T. That is, the transmitting areas T are disposed around the active areas A, respectively. That is, the transmitting areas T are surrounded by the active areas A, respectively.

The active areas A are connected to each other. In detail, edge areas of the active areas A may be connected to each other. That is, the edge areas of the active areas A may be adjacent to each other.

Also, each of the active areas A has a length greater than that of each of the transmitting areas T.

Thus, the active areas A may be adjacent to each other and connected to each other.

The solar cell layer 101 are divided into a plurality of solar cells C1,..., and, Cn. The solar cells C1,..., and, Cn may include a first cell C1, a second cell C2, and a third cell C3.

The solar cells C1,..., and, Cn may include a first cell C1, a second cell C2, and a third cell C3.

Each of the active areas A includes a CIGS light absorption layer 300. Each of the transmitting areas T may include a transmitting groove 20 for selectively exposing the substrate 10 and a transparent insulation layer disposed within the transmitting groove 20.

For example, the active areas A and the transmitting areas T of the first cell C1 may be alternately disposed. The active areas A and the transmitting areas T of the second cell C2 may be alternately disposed. The active areas A and the transmitting areas T of the third cell C3 may be alternately disposed.

That is, the active areas A of the first cell C1 may be separated from each other by the transmitting areas T of the first cell C1. Similarly, the active areas A of the second cell C2 may be separated from each other by the transmitting areas T of the second cell C2. Also, the active areas A of the third cell C3 may be separated from each other by the transmitting areas T of the third cell C3.

The active areas A of the first cell C1 are adjacent to the transmitting areas T of the second cell C2. Also, the active areas A of the first cell C1 are connected to the transmitting areas T of the second cell C2. In detail, edge areas of the active areas A of the first cell C1 are connected to edge areas of the active areas A of the second cell C2. Also, two active areas A of the active areas A of the first cell C1 may be connected to one of the active areas A of the second cell C2.

For example, each of the active areas A of the first and second cells C1 and C2 may have a first length D1, and each of the transmitting areas T may have a second length D2 less than the first length D1.

That is, when based on a horizontal direction that is an X-axis, the transmitting areas T of the first cell C1 and the transmitting areas T of the second cell C2 may be mutually disposed in a zigzag form and thus spaced from each other.

When based on a vertical direction that is a Y-axis, the active areas A of the first cell C1 and the active areas A of the second cell C2 may be mutually disposed in a zigzag form, and thus edge areas thereof may be connected to each other.

As described above, in the solar cell layer 101, the active areas A and the transmitting areas T may be disposed in a mosaic shape or a tile shape to minimize losses of an output current.

Specifically, in one cell, a portion of the active area A may be removed and used as the transmitting area T to expand a light transmitting area.

Also, edges of the active areas A of the cells C1, ..., and, Cn may be connected in a bridge shape. Thus, the cells C1,..., and, Cn may be electrically connected to each other. That is, the active areas A of the cells C1,..., and, Cn may be connected to each other in an X-axis direction of the substrate 10. Thus, series connection properties of the solar cell layer 101 may be improved to improve the output current.

Also, the transmitting areas T may be selectively disposed between the cells C1,..., and, Cn to improve transmittance of external light. A bus bar may be connected to each of the first cell C1 and n-th cell Cn.

Thereafter, an eva film 900 may be stacked on the solar cell layer 101.

A structure of the solar cell panel according to the current embodiment will be described in detail with reference to Figs. 19 to 21.

Fig. 19 is a sectional view taken along line N1-N2 of Fig. 17. That is, Fig. 19 is a sectional view illustrating a structure of the transmitting area T disposed between the active areas A of the second cell C2 on the basis of a horizontal axis. Fig. 20 is a sectional view taken along line L1-L2 of Fig. 17. Fig. 20 is a sectional view illustrating an area having a structure in which the first, second, and third cells C1, C2, and C3 are separated by the transmitting area T. Fig. 21 is a sectional view taken along line M1-M2 of Fig. 17. That is, Fig. 21 is a sectional view illustrating a bridge area by which the first, second, and third cells C1, C2, and C3 are connected to each other.

Referring to Figs. 19 to 21, the solar cell layer 101 includes a back electrode layer 200, a light absorption layer 300, a buffer layer 400, a high-resistance buffer layer 500, and a front electrode layer 800, which are successively stacked on the substrate 100.

The back electrode layer 200 is divided into a plurality of back electrodes 210, 220,... by a plurality of first through holes P1. That is, the first through holes P1 may selectively expose the substrate 100 and define the back electrodes 210, 220... The back electrodes 210, 220,... are disposed on the active areas A, respectively.

The light absorption layer 300 is divided into a plurality of light absorption parts 310, 320,... by a plurality of second through holes P2. That is, the second through holes P2 may selectively expose a top surface of the back electrode layer 200 and define the light absorption parts 310, 320,...

The light absorption parts 310, 320,... are disposed on the active areas A, respectively.

The front electrode layer 800 is divided into a plurality of front electrodes 810, 820,... by a plurality of third through holes P3. That is, the third through holes P2 may selectively expose a top surface of the back electrode layer 200 and define the front electrodes 810, 820,... The front electrodes 810, 820,... are disposed on the active areas A, respectively.

The solar cell layer 101 are divided into the plurality of cells C1,..., and, Cn by the third through holes P3. Also, the third through holes P3 are defined among the cells C1,..., and, Cn, respectively. Also, each of the third through holes P3 is defined between the active area A and the transmitting area T.

Each of the active areas A includes one back electrode, one light absorption part, the buffer layer 400, the high-resistance buffer layer 500, and one front electrode, which are successively stacked. The light absorption parts 310, 320,... and the front electrodes 810, 820,... may be PN-junctioned with each other, and the active areas A may generate photoelectrons by incident light.

Also, transmitting grooves 20 are defined in the transmitting areas T, respectively. Each of the transmitting grooves 20 is a groove in which portions of the back electrode layer 200, the light absorption layer 300, the buffer layer 400, the high-resistance buffer layer 500, and the front electrode layer 800 are moved to expose a top surface of the substrate 100.

That is, since the transmitting areas T do not include the back electrode and the light absorption layer which are opaque, light is not transmitted. Only the substrate 100 and eva film 900 may be disposed on the transmitting areas T, and the substrate 100 and the eva film 900 may be transparent.

The transmitting groove 20 may be defined in each of the transmitting areas T, and the eva film 900 may be disposed within the transmitting groove 20. That is, a portion of the eva film 900 may be inserted into the transmitting groove 20.

Each of the active areas A of the first cell C1 includes a first back electrode 210, a first light absorption part 310, the buffer layer 400, the high-resistance buffer layer 500, and a first front electrode, which are successively stacked.

Each of the active areas A of the second cell C2 includes a second back electrode 220, a second light absorption part 320, the buffer layer 400, the high-resistance buffer layer 500, and a second front electrode, which are successively stacked.

Each of the active areas A of the third cell C3 includes a third back electrode 230, a third light absorption part 330, the buffer layer 400, the high-resistance buffer layer 500, and a third front electrode, which are successively stacked.

The first light absorption part 310, the buffer layer 400 of the first cell C1, and the first front electrode 810 may extend up to a non active area NA. That is, the first light absorption part 310 and the first front electrode 810 may extend up to a second back electrode pattern 225 of the second cell C2.

The first front electrode 810 may extend and be connected to the second back electrode pattern 225 through the second through holes P2 of the non active area NA.

The transmitting areas T transmitting light may extend to upper portions of the first and third cells C1 and C3. For example, the transmitting areas T may be formed using the eva film 900. That is, the eva film 900 disposed on the solar cell layer 101 may be inserted into the transmitting groove to form the transmitting areas T.

The transmitting areas T may be defined by the transmitting groove 20 defined by selectively removing the active area A of the second cell C2 disposed between the first cell C1 and the third cell C3. Also, each of the transmitting areas T may have the same width as that of the active area A.

When viewed on the whole, the solar cell layer 101 may have a structure in which the active area A and the transmitting areas T are alternately disposed.

Referring to Fig. 21, the active area A of the first cell C1, the active area A of the second cell C2, and the active area A of the third cell C3 are connected to each other in series.

That is, the first front electrode 810 is electrically and physically connected to the second back electrode 220 through the first connection line 801. Specifically, the first connection line 801 is disposed within the second through hole P2 between the first cell C1 and the second cell C2.

Also, the second front electrode 820 is electrically and physically connected to the third back electrode 230 through a second connection line 802. Specifically, the second connection line 802 is disposed inside the second through hole P2 between the second cell C2 and the third cell C3.

The first, second, and third cells C1, C2, and C3 may be separated into unit cells by the third through holes P3 corresponding to a third device isolation area. Also, the eva film 900 is disposed on the first, second, and third cells C1, C2, and C3.

Here, the active areas A of the first, second, and third cells C1, C2, and C3 may be electrically connected to each other through the first connection line 801 and the second connection line 802. In detail, the active areas A of the first cell C1 may be electrically connected to the active areas A of the final cell Cn through the active areas A of the second and third cells C2 and C3.

Thus, since the solar cells C1,..., and, Cn are connected to each other in a bridge shape in series, losses of an output current may be minimized.

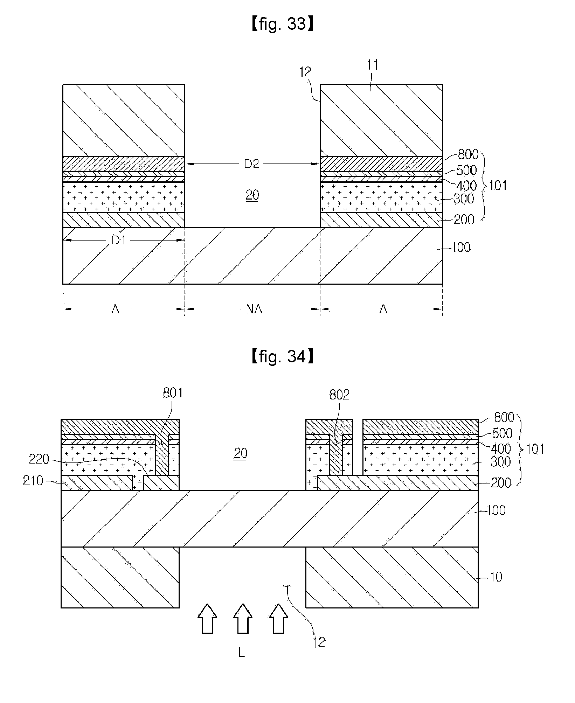

Figs. 22 and 33 are views illustrating a process of manufacturing the solar cell panel according to the second embodiment. This manufacturing process according to the current embodiment will be described with reference to the above-described solar cell panels. The above-described solar cell panel and the method of manufacturing the same may be essentially applied to the current embodiment.

Referring to Fig. 22, a back electrode layer 200 is formed on a substrate 100.

The substrate 100 may be formed of glass. Also, the substrate 100 may include a ceramic substrate 100, a metal substrate 100, and a polymer substrate 100.

For example, the glass substrate 100 may be formed of soda lime glass or high strained point soda glass. The metal substrate 100 may include a substrate 100 formed of a stainless steel or titanium. The polymer substrate 100 may be formed of polyimide.

The substrate 100 may be transparent. The substrate 100 may be rigid or flexible.

The back electrode layer 200 is formed of a conductor such as a metal.

Since the back electrode layer 200 is formed of a metal, series resistance properties may be improved to improve conductivity.

For example, the back electrode layer 200 may be formed using a molybdenum (Mo) target through a sputtering process.

This is done because of high conductivity of Mo, ohmic contact with a light absorption layer 300, and high-temperature stability under Se atmosphere.

A Mo thin film that is the back electrode layer 200 should have a low specific resistance as an electrode and also superior adhesion with the substrate 100 so that it prevent exfoliation from occurring by a difference of a thermal expansion coefficient.

However, the present disclosure is not limited thereto. For example, the back electrode layer 200 may be formed of Mo doped with Na ions.

Although not shown, the back electrode layer 200 may include at least one layer. When the back electrode layer 200 includes a plurality of layers, the layers constituting the back electrode layer 200 may be formed of materials different from each other.

Referring to Fig. 23, a plurality of first through holes P1 are formed in the back electrode layer 200. Accordingly, the back electrode layer 200 is divided into a plurality of back electrodes 210, 220,... A top surface of the substrate 100 may be selectively exposed through the first through holes P1.

For example, the first through holes P1 may be patterned through a laser process or a mechanical process. The back electrodes 210, 220,... may be disposed in a stripe shape or a matrix shape by the first through holes P1 to correspond to each cell.

The plurality of back electrodes 210, 220,... may include a first back electrode 210, a second back electrode 220, and a third electrode 230.

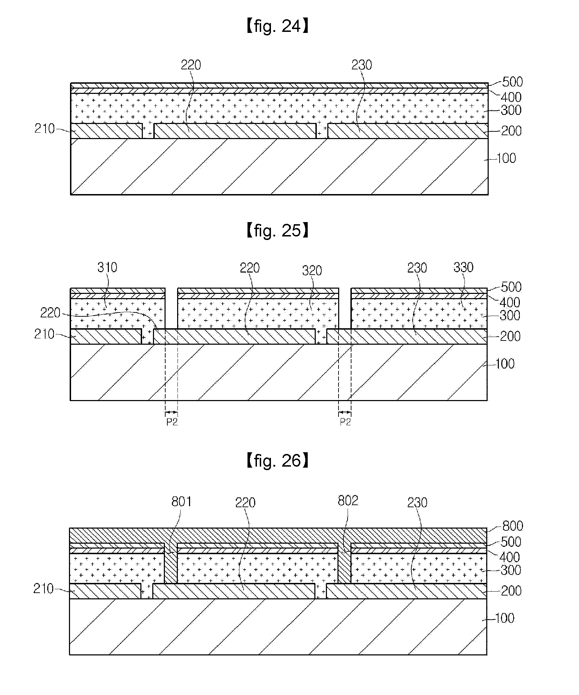

Referring to Fig. 24, the light absorption layer 300 is formed on the back electrode layer 200 to gap-fill the first through holes P1. The light absorption layer 300 may be formed of a P-type semiconductor compound. The light absorption layer 300 is formed of a group I-III-VI-based compound. In detail, the absorption layer 300 is formed of a Cu(In, Ga)Se2-based (CIGS-based) compound.

On the other hand, the light absorption layer 300 may be formed of a CuInSe2-based (CIS-based) compound or a Cu, Ga, Se2-based (CGS-based) compound.

For example, the light absorption layer 300 is formed using a Cu target, an In target, and a Gs target. A CIG-based metal precursor layer is formed on the back electrodes 210, 220...

Thereafter, the metal precursor layer reacts with Se through a selenization process to form a CIGS-based light absorption layer.

Also, a co-evaporation process using Cu, In, Ga, and Se may be performed form the light absorption layer 300.

The light absorption layer 300 receive external light to convert the light into electrical energy. The light absorption layer 300 generates a photoelectron-motive force by a photoelectric effect.

A buffer layer 400 and a high-resistance buffer layer 500 are formed on the light absorption layer 300.

At least one or more buffer layers 400 may be formed on the light absorption layer 300. Cadmium sulfide may be stacked using a chemical bath deposition (CBD) to form the buffer layer 400.

Here, the buffer layer 400 may be an N-type semiconductor layer, and the light absorption layer 300 may be a P-type semiconductor layer. Thus, the light absorption layer 300 and the buffer layer 400 are PN-junctioned with each other.

A sputtering process may be performed on the high-resistance buffer layer 500 using ZnO as a target to further form a ZnO layer on the CdS.

The high-resistance buffer layer 500 may be formed as a transparent electrode layer on the buffer layer 400.

For example, the high-resistance buffer layer 500 may be formed of one of ITO, ZnO, and i-ZnO.

The buffer layer 400 and the high-resistance buffer layer 500 are disposed between the light absorption layer 300 and a front electrode that will be formed later.

That is, since each of the light absorption layer 300 and the front electrode layer 800 has a large difference between an energy band gap and a lattice constant, the buffer layer 400 and the high-resistance buffer layer 500 having about middle band gap values of the band gap values of the light absorption layer 300 and the front electrode layer 800 may be inserted to realize good junction.

Although the two buffer layers 400 and 500 are formed on the light absorption layer 300 in the current embodiment, the present disclosure is not limited thereto. For example, only one buffer layer may be formed on the light absorption layer 300.

Referring to Fig. 25, a plurality of second through holes P2 passing through the high-resistance buffer layer 500, the buffer layer 400, and the light absorption layer 300 are formed. The back electrode layer 200 may be selectively exposed through the second through holes P2.

The second through holes P2 may be formed using a mechanical device such as a tip, or a laser device. The second through holes P2 may be disposed adjacent to the first through holes P1, respectively.

The light absorption layer 300 is divided into a plurality of light absorption parts 310, 320,... by the second through holes P2. That is, the light absorption parts 310, 320,... are defined by the second through holes P2.

Referring to Fig. 26, a transparent conductive material is stacked on the high-resistance buffer layer 500 to form the front electrode layer 800. When the front electrode layer 800 is formed, the transparent conductive material may be inserted into the second through holes P2 to form a first connection line 801 and a second connection line 802.

Thus, the solar cell layer 101 including the back electrode layer 200, the light absorption layer 300, the buffer layer 400, the high-resistance buffer layer 500, and the front electrode layer 800 is formed.

The first connection line 801 may be electrically and physically connected to the second back electrode 220 through the second through holes P2. The second connection line 802 may be electrically and physically connected to the third back electrode 230 through the second through holes P2.

A sputtering process may be performed to form ZnO doped with Al or Al₂O₃, thereby forming the front electrode layer 800.

The front electrode layer 800 is a window layer which is PN-junctioned with the light absorption layer 300. Thus, since the front electrode layer 800 serves as a transparent electrode of a front surface of the solar cell, the front electrode layer 800 may be formed of ZnO having high light transmittance and electrical conductivity. Thus, since the ZnO is doped with Al or Al₂O₃, an electrode having low resistance may be formed.

A ZnO thin film that is the front electrode layer 800 may be deposited through a radio frequency (RF) sputtering process using a ZnO target, through a reactive sputtering process using a Zn target, or through a metal organic chemical vapor deposition process.

Also, a dual structure in which an indium thin oxide (ITO) thin film having superior electro-optical properties is deposited on the ZnO thin film may be formed.

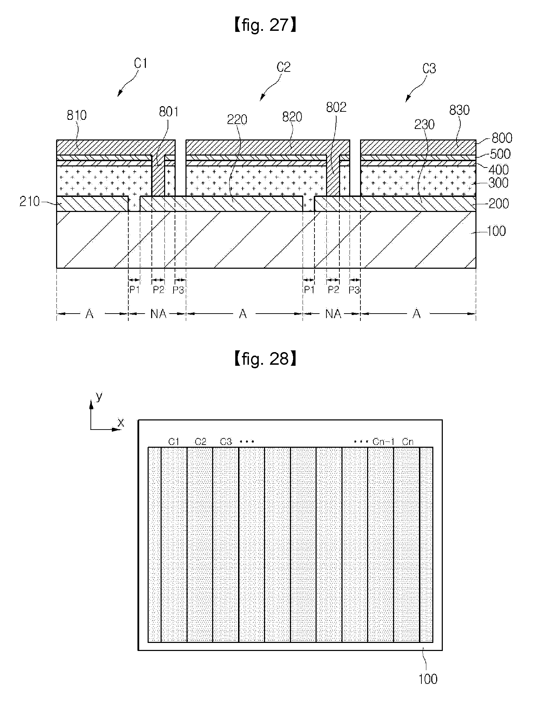

Referring to Fig. 27, third through holes P3 passing through the front electrode layer 800, the high-resistance buffer layer 500, the buffer layer 400, and the light absorption layer 300 are formed. A top surface of the back electrode layer 200 may be selectively exposed through the third through holes P3. The third through holes P3 may be disposed adjacent to the second through holes P2, respectively.

The third through holes P3 may be formed by irradiating a laser or using a mechanical device such as a tip.

The front electrode layer 800 is divided into a plurality of front electrodes 810, 820,... by the third through holes P3. Also, the light absorption layer 300, the buffer layer 400, the high-resistance buffer layer 500, and the front electrode layer 800 may be divided into unit cells by the third through holes P3.

That is, as shown in Figs. 17 and 27, a plurality of cells C1,..., and, Cn may be defined in the solar cell layer 101 by the third through holes P3.

As shown in Figs. 27 and 28, the cells C1,..., and Cn formed by the third through holes P3 may be disposed in a strip shape. That is, the third through holes P3 may be formed in a vertical direction that is a Y-axis direction of the substrate 100. Also, the first, second, and third cells C1, C2, and C3 may be separated from each other by the third through holes P3.

Here, the first connection line 801 extending from the first front electrode 810 may be connected to the second back electrode 220 through the second through hole P2 between the first cell C1 and the second cell C2. The second connection line 802 extending from the second front electrode 820 may be connected to the third back electrode 230 through the second through hole P2 between the second cell C2 and the third cell C3.

That is, the first, second, and third cells C1, C2, and C3 may be electrically connected to each other by the first and second connection lines 801 and 802.

The cells C1,..., and, Cn may be connected to each other in series by the front electrodes 810, 820,... and the connection lines 801 and 802.

The cells C1,..., and, Cn may be classified into an active area A in which solar light is converted into electrical energy and a non active area NA in which solar light is not converted into electrical energy.

An area between the first through hole P1 and the third through hole P3 corresponding to an area between the cells C1,..., and, Cn may be the non active area NA. That is, areas from the first through hole P1 to the third through hole P3 may be dead zone areas in which a power is not generated.

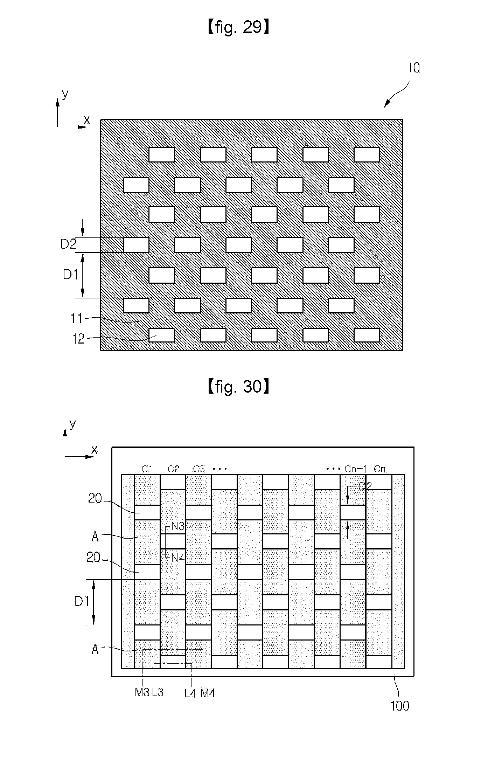

Referring to Figs. 29 and 30, a mask 10 is formed on the front electrode layer 800. Fig. 29 is a plan view of the mask 10, and Fig. 30 is a plan view of the solar cell layer 101 patterned in Fig. 29.

Referring to Fig. 29, the mask 10 includes a plurality of light blocking parts 11 and a plurality of exposing parts 12. The mask 10 may have a structure corresponding to a plane shape of the solar cell layer 101. For example, an X-axis and Y-axis of the mask 10 may be arranged corresponding to an X-axis and Y-axis of the solar cell layer 101 illustrated in Fig. 28.

In the mask 10, the light blocking parts 11 and the exposing parts 12 are alternately formed with respect to a vertical direction that is the Y-axis. When the mask 10 is disposed on the cells C1,..., and, Cn, the transmitting areas T may be selectively exposed by the light blocking parts 11 and the exposing parts 12.

For example, each of the light blocking parts 11 may have a first length D1 with respect to the vertical direction, and each of the exposing parts 12 may have a second length D2 less than the first length D1.

In the mask 10, the exposing parts 12 may be dislocated with the adjacent exposing parts 12 in a zigzag shape with respect to the horizontal direction that is the X-axis.

That is, the light blocking parts 11 may be disposed around one exposing part 12.

The light blocking parts 11 may be dislocated with the adjacent light blocking parts 11 in a zigzag shape with respect to the horizontal direction of the mask 10. Also, edge areas of the light blocking parts 11 may be connected to edge areas of the adjacent light blocking parts 11.

That is, the exposing parts 12 and the adjacent exposing parts 12 may not contact each other and be alternately disposed in the X-axis direction and the Y-axis direction of the mask 10. The light blocking parts 11 and the adjacent light blocking parts 11 may be alternately disposed and partially connected to each other.

Referring to Figs. 30 to 33, an etching process is performed on the solar cell layer 101 using the mask 10 as an etch mask. A transmitting groove 20 for selectively exposing the substrate 100 is formed in each of the solar cells C1,..., and, Cn using the mask 10.

The active area A of each of the solar cells C1,..., and, Cn may be defined by the transmitting groove 20. That is, the active area A of each of the solar cells C1,..., and, Cn is formed by the light blocking part 11 of the mask 10, and the transmitting groove 20 of each of the solar cells C1,..., and, Cn is formed by the exposing parts 12.

For example, the active areas A and the transmitting areas T of the first and second cells C1 and C2 may be alternately formed with respect to the vertical direction that is the Y-axis. The transmitting groove 20 of the first cell C1 and the transmitting groove 20 of the second cell C2 may be mutually disposed in a zigzag form with respect to the vertical direction that is the X-axis.

The active areas A of the first cell C1 and the active areas A of the second cell C2 may be mutually disposed in a zigzag form with respect to the horizontal direction that is the X-axis, and thus edge areas thereof may be connected to each other.

That is, the active areas A corresponding to the first and second cells C1 and C2 may be separated from each other by the transmitting groove 20. The active area A of the first cell C1 may be selectively connected to the active area A of the second cell C2. That is, the active areas A of the solar cells C1,..., and, Cn may be connected to each other in a bridge shape. Thus, the solar cells C1,..., and, Cn may be connected to each other in series.

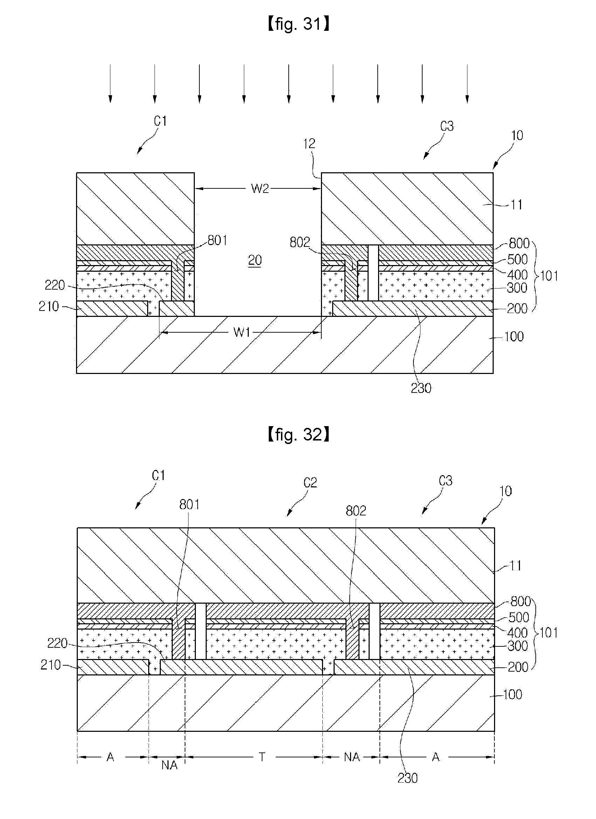

The etching process using the mask 10 will be described in detail with reference to Figs. 31 to 33.

Fig. 31 is a sectional view taken along line L3-L4 of Fig. 30, Fig. 32 is a sectional view taken along line M3-M4 of Fig. 30, and Fig. 33 is a sectional view taken along line N3-N4 of Fig. 30.

A photoresist layer may be formed on the substrate 100 including the front electrode layer 800, and then a photolithography process may be performed to form the exposing parts 12 for selectively exposing the front electrode layer 800, thereby manufacturing the mask 10.

For example, the second back electrode 220 may have a first width W1, and each of the exposing parts 12 may have a second width W2 less than the first width W1.

The second width W2 of each of the exposing parts 12 may be a width corresponding from the second back electrode 220 exposed by the third through hole P3 disposed at a side of the first connection line 801 to the other end of the second back electrode 220.

That is, the exposing parts 12 may expose the front electrode layer 800 corresponding to the active area A of the second cell C2.

The light blocking part 11 may cover the front electrode layer 800 corresponding to the active area A and the non active area NA of the first cell C1. Also, the light blocking part 11 may cover the front electrode layer 800 corresponding to the active area A and the non active area NA of the third cell C3.

The etching process using the mask 10 is performed to form the transmitting groove 20. A top surface of the substrate 100 corresponding to the active area A of the second cell C2 may be exposed by the transmitting groove 20.

The first and second cells C1 and C3 may be separated from each other by the transmitting groove 20.

The formation of the transmitting groove 20 will now be described in detail.

A first etching process is performed using the mask 10 as an etch mask.

The first etching process is a process for etching the front electrode layer 800 exposed by the exposing parts 12 and the high-resistance buffer layer 500.

For example, the first etching process is performed using HCl.

The front electrode layer 800 and the high-resistance buffer layer 500 may be selectively removed through the first etching process to expose the buffer layer 400.

Next, a second etching process is performed using the mask 10 as an etch mask.

The second etching process is a process for etching the buffer layer exposed by the mask 10 and the light absorption layer 300.

For example, the second etching process is performed using H₂SO₄.

The buffer layer 400 and the light absorption layer 300 may be selectively removed through the second etching process to expose the back electrode 220.

Next, a third etching process is performed using the mask 10 as an etch mask.

The third etching process is a process for etching the second back electrode 220 exposed by the mask 10.

For example, the third etching process is performed using molybdenum etchant including one of phosphoric acid, nitric acid, acetic acid, and hydrogen peroxide.

The second back electrode 220 corresponding to the active area A of the second cell C2 is removed through the third etching process to form the transmitting groove 20 exposing the substrate 100.

Here, the second back electrode 220 corresponding to the active area A of the second cell C2 is removed, and the second back electrode pattern 225 remains on the non active area NA.

The first and second cells C1 and C3 may be separated from each other by the transmitting groove 20.

The transmitting groove 20 may have a width corresponding to that of each of the exposing parts 12 of the mask 10. Specifically, since the exposing parts 12 of the mask 10 may be adjusted in width, the transmitting groove 20 may also be adjusted in width.

Fig. 32 is a sectional view illustrating the active area A of the solar cell which is not affected by the etching process.

Referring to Fig. 32, only the light blocking part 11 of the mask 10 may be disposed on the first, second, and third cells C1, C2, and C3.

Thus, when the etching process for forming the transmitting groove 20 is performed, the first, second, and third cells C1, C2, and C3 covered by the mask 10 may be protected.

Thus, the active areas A of the first, second, and third cells C1, C2, and C3 may be electrically connected to each other.

Fig. 33 is a sectional view illustrating a structure in which the active area A of the second cell C2 is selectively removed to form an opening 15.

The mask 10 is formed on the second cell C2 to form the transmitting groove 20 exposing the substrate 100.

The front electrode layer 800 may be selectively exposed through the exposing parts of the mask 10.

The etching process using the mask 10 is performed to form the transmitting groove 20 between the active areas A of the second cell C2. The etching process for forming the transmitting groove 20 in the second cell C2 is performed together with the etching process of Fig. 31.

The active areas A of the second cell C2 are separated from each other by the transmitting groove 20.

That is, the active areas A of the first cell C2 may be physically and electrically separated from each other by the transmitting groove 20.

The active area A of the second cell C2 may have a first length D1 corresponding to that of the light blocking part 11. The transmitting groove 20 of the second cell C2 may have a second length D2 corresponding to that of each of the exposing parts 12.

Although the selective etching process is performed to form the transmitting groove 20 in the solar cells C1,..., and, Cn, the present disclosure is not limited thereto.

Referring to Fig. 34, the mask 10 may be formed on a back surface of the substrate 100. Since the mask 10 has the same shape as that of the mask 10 of Fig. 29, its detailed descriptions will be omitted. That is, the mask 10 may selectively expose the substrate 100 corresponding to the active area A of the second cell C2.

Next, a laser process (e.g., Nd-YAG laser) using the mask 10 as an etch mask may be performed.

The laser process may be performed to selectively remove the second back electrode 220, the light absorption layer 300, the buffer layer 400, the high-resistance buffer layer 500, and the front electrode layer 800 corresponding to the exposing parts 12 of the mask 10 to form the transmitting groove 20.

Thereafter, an ashing process may be performed to remove the mask 10.

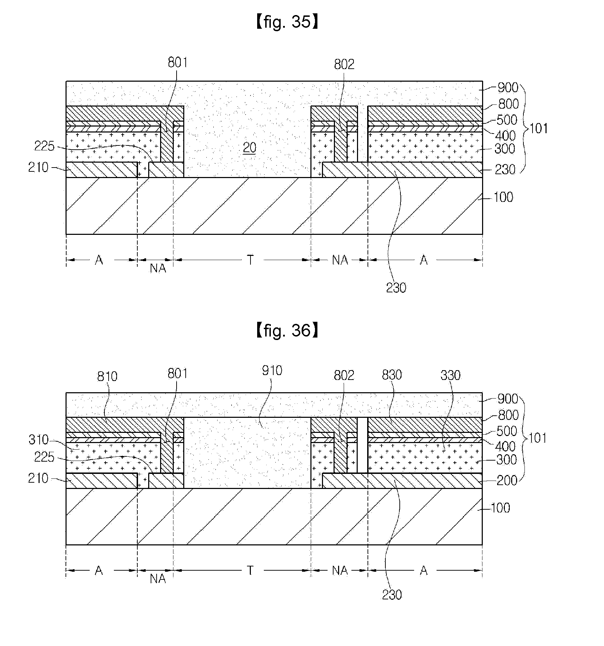

Referring to Fig. 35, a lamination process may be performed on the substrate 100 including the transmitting groove 20 to allow an eva film 900 to adhere.

The eva film 900 may be gap-filled into the transmitting groove 20 to form the transmitting area T.

Bus bars connected to the cells disposed on edges of the solar cells C1,..., and, Cn are formed before the eva film 900 is formed.

Fig. 36 is a sectional view illustrating a modified example of the transmitting areas T.

Referring to Fig. 36, a transparent insulation material 910 may be gas-filled into the transmitting grooves 20 to form the transmitting areas T.

The transparent insulation material 910 may be a material having heat resistance of about 100°C to about 200°C, light transmittance of about 90% to about 100%, strong alkaline resistance, solar resistance, and insulating resistance.

For example, the transparent insulation material 910 may be formed of one of poly methyl methacrylate (PMMA) and acrylonitrile which are transparent amorphous resins and SAN, poly cabornate (PC), transparent acrylonitrile butadiene styrene (ABS), polyethylene terephtalate (PET), ultra high molecular weight (U-HMW) ployethylene, methyl cellulose (MC), poly oxy methylene (POM), polytetrafluoroethylene (PTEE), polypropylene oxide (PPO), and polyurethane (PUR) which are copolymers of styrene.

Also, the transparent insulation material 910 may be formed of a positive or negative photoresist.

The transparent insulation material 910 may be selectively formed within the transmitting grooves 20 through a deposition, thermal absorption, injection, or filling process.

Also, a color may be added to the transparent insulation material 910 to form color transmitting areas T.

Thereafter, a lamination process may be performed on the front electrode layer 800 including the transparent insulation material 910 to form an eva film 900.

According to the current embodiment, an active area A and a non active area NA may be defined on the substrate 100 by the transmitting areas T.

The active area A may generate a photoelectron-motive force, and the transmitting areas T may transmit light.

The active area A and the transmitting areas T may be formed in a mosaic shape to improve power generation efficiency and transmittance at the same time.

In the solar cell apparatus according to the embodiments, the first active areas and the second transmitting areas are adjacent to each other. Thus, the active areas A and the transmitting areas T may be disposed in the mosaic shape.

Thus, a distance between the active areas may be closer to reduce the electrical losses occurring between the active areas. Specifically, the transparent electrode may be disposed on the transmitting area to connect the active areas to each other. Here, since a path of a current flowing through the transparent electrode is short, the solar cell apparatus according to the embodiments may have improved electrical properties.

Also, the transmitting areas may include the lower transparent electrode and the upper transparent electrode. Thus, the back electrode of the active areas may be connected to the lower transparent electrode, and the front electrode of the active areas may be connected to the upper transparent electrode. Thus, in the solar cell apparatus according to the embodiments, a resistance between the active areas may be reduced to improve the electrical properties.

Also, in the solar cell apparatus according to the embodiments, desired portions of the light absorption layer and the back electrode layer may be removed to form the transmitting area. Thus, in the solar cell apparatus according to the embodiments, the transmitting area may be disposed in a desired position to realize the improved outer appearance and light transmittance.

Also, the solar cell apparatus according to the embodiments may realize a color on the transparent insulation layer disposed on the transmitting area.

Also, in the solar cell apparatus according to the embodiments, the transmitting area may be formed through the mask process. Thus, the transmitting area may be easily controlled in position, size, and shape. The solar cell apparatus according to the embodiments may improve the transmittance and the esthetic function thereof. Specifically, when the solar cell apparatus according to the embodiments is used as the exterior finishing material of the buildings, the esthetic function may be further improved by the transmitting area.

Also, in the solar cell apparatus according to the embodiments, the active areas may be connected to each other. The active areas may be directly connected to each other. Thus, the active areas and the transmitting areas may be disposed in the mosaic shape. Here, the edge portions of the active areas may be connected to each other to reduce a connection resistance between the active areas.

That is, in the solar cell apparatus according to the embodiments, the active areas may be connected to each other in series in the bridge shape to minimize the loss of the output current.

Thus, the solar cell apparatus according to the embodiments has the improved electrical properties. Specifically, since the transmitting area may be disposed at a desired position, the solar cell apparatus according to the embodiments may satisfy the improved transmittance and the improved electrical properties at the same time.

The solar cell apparatus according to the embodiments may be used in photovoltaic power generation fields.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell apparatus comprising:
a substrate;
a first cell disposed on the substrate; and
a second cell disposed on the substrate, the second cell being adjacent to the first cell,
wherein the first cell comprises a plurality of first active areas and a plurality of first transmitting areas which are alternately disposed with respect to each other,
the second cell comprises a plurality of second active areas and a plurality of second transmitting areas which are alternately disposed with respect to each other, and
the first active areas are adjacent to the second transmitting areas, respectively.

2. The solar cell apparatus according to claim 1, wherein the first active areas are disposed in a diagonal direction with respect to the second active areas.

3. The solar cell apparatus according to claim 1, wherein each of the first active areas comprises:
a first back electrode disposed on the substrate;
a first light absorption part disposed on the first back electrode; and
a first front electrode disposed on the first light absorption part,
wherein each of the second transmitting areas comprises:
a second lower transparent electrode connected to the first front electrode;
a second transparent insulation layer disposed on the second lower transparent electrode; and
a second upper transparent electrode disposed on the second transparent insulation layer.

4. The solar cell apparatus according to claim 3, wherein each of the second active areas comprises:
a second back electrode disposed on the substrate;
a second light absorption part disposed on the second back electrode; and
a second front electrode disposed on the second light absorption part.

5. The solar cell apparatus according to claim 4, wherein the second back electrode is connected to the second lower transparent electrode.

6. The solar cell apparatus according to claim 4, wherein the second upper transparent electrode is integrated with the second front electrode.

7. The solar cell apparatus according to claim 3, further comprising a third cell adjacent to the second cell,
wherein the third cell comprises a plurality of third active areas and a plurality of third transmitting areas which are alternately disposed with respect to each other, and
the third active areas are adjacent to the second transmitting areas, respectively.

8. The solar cell apparatus according to claim 7, wherein each of the third active areas comprises:
a third back electrode disposed on the substrate, the third back electrode being connected to the second upper transparent electrode;
a third light absorption part disposed on the third back electrode; and
a third front electrode disposed on the third light absorption part.

9. A solar cell apparatus comprising:
a substrate; and
a solar cell layer disposed on the substrate,
wherein the solar cell layer comprises a plurality of active areas and a plurality of transmitting areas which are alternately disposed with respect to each other, and
each of the transmitting areas comprises:
a lower transparent electrode disposed on the substrate;
a transparent insulation layer disposed on the lower transparent electrode; and
an upper transparent electrode disposed on the transparent insulation layer.

10. The solar cell apparatus according to claim 9, wherein the solar cell layer has a mosaic shape by the transmitting areas and the active areas.

11. The solar cell apparatus according to claim 9, wherein grooves are defined between the transmitting areas and the active areas in the solar cell layer, respectively.

12. A method of manufacturing a solar cell apparatus, the method comprising:
forming a back electrode layer on a substrate;
forming a light absorption layer on the back electrode layer;
patterning the back electrode layer and the light absorption layer to form a plurality of transmitting grooves;
forming a lower transparent electrode inside each of the transmitting grooves;
forming a transparent insulation layer on the lower transparent electrode; and
forming a front electrode layer on the light absorption layer and the transparent insulation layer.

13. The method according to claim 12, further comprising forming a second through hole adjacent to the transparent insulation layer in the light absorption layer.

14. The method according to claim 13, wherein, in the forming of the front electrode layer, a transparent conductive material is filled into the second through hole, and
a portion of the transparent conductive material filled into the second through hole is removed to form a third through hole in the front electrode layer.

15. The method according to claim 13, further comprising forming a third through hole adjacent to the second through hole in the front electrode layer.

16. The method according to claim 15, wherein the transparent insulation layer is exposed through the third through hole.

17. The method according to claim 12, wherein the forming of the transmitting grooves comprises:
disposing a mask comprising openings respectively corresponding to the transmitting grooves on the light absorption layer; and
partially etching the light absorption layer and the back electrode layer using the mask.

18. A solar cell apparatus comprising:
a substrate;
a first cell disposed on the substrate; and
a second cell disposed on the substrate, the second cell being adjacent to the first cell,
wherein the first cell comprises a plurality of first active areas and a plurality of first transmitting areas which are alternately disposed with respect to each other,
the second cell comprises a plurality of second active areas and a plurality of second transmitting areas which are alternately disposed with respect to each other, and
the first active areas are connected to the second active areas.

19. The solar cell apparatus according to claim 18, wherein the first active areas are connected to the second active areas in series.

20. The solar cell apparatus according to claim 18, wherein the first active areas and the second active areas are disposed in a zigzag shape.

21. The solar cell apparatus according to claim 18, wherein edge areas of the first active areas are connected to edge areas of the second active areas.

22. The solar cell apparatus according to claim 18, wherein two active areas of the first active areas are connected to one active area of the second active areas.

23. The solar cell apparatus according to claim 22, wherein two active areas of the second active areas are connected to one active area of the first active areas.

24. The solar cell apparatus according to claim 18, wherein each of the first active areas comprises:
a first back electrode disposed on the substrate;
a first light absorption part disposed on the first back electrode; and
a first front electrode disposed on the first light absorption part, and
each of the second active areas comprises:
a second back electrode disposed on the substrate;
a second light absorption part disposed on the second back electrode; and
a second front electrode disposed on the second light absorption part,
wherein the first front electrode is connected to the second back electrode.

25. The solar cell apparatus according to claim 18, further comprising a third cell adjacent to the second cell,
wherein the third cell comprises a plurality of third active areas and a plurality of third transmitting areas which are alternately disposed with respect to each other, and
the second active areas are connected to the third active areas.

26. The solar cell apparatus according to claim 18, wherein edge areas of the second active areas are connected to edge areas of the third active areas.

27. The solar cell apparatus according to claim 18, wherein each of the first active areas has a length greater than that of each of the first transmitting areas.

28. A method of manufacturing a solar cell apparatus, the method comprising:
forming a back electrode layer on a substrate;
forming a light absorption layer on the back electrode layer;
forming a front electrode layer on the light absorption layer; and
patterning the back electrode layer, the light absorption layer, and the front electrode layer to form a plurality of active areas and a plurality of transmitting areas,
wherein the active areas are adjacent and connected to each other, and
the transmitting areas are spaced from each other.

29. The method according to claim 28, further comprising forming third through holes in the front electrode layer and the light absorption layer,
wherein the transmitting areas are formed between the third through holes, respectively.

30. The method according to claim 28, wherein the active areas and the transmitting areas are formed in a mosaic shape.

31. The method according to claim 28, wherein the forming of the transmitting areas comprises:
forming a mask comprising openings respectively corresponding to the transmitting areas on the front electrode layer; and
partially etching the back electrode layer, the light absorption layer, and the front electrode layer using the mask.

32. The method according to claim 28, wherein the active areas are connected to each other in series.
